# EUROPEAN PATENT APPLICATION

(11) **EP 4 822 697 A1**
(43) Date of publication of application: **14.10.2026**
(21) Application number: 26171181.6
(22) Date of filing: 08.04.2026
(51) Int. Cl.: G11C 7/18, G11C 5/06

(54) **MEMORY DEVICE USING SHUNT BITLINES OR SHUNT FLYING BITLINES**

(30) Priority: 10.04.2025 US 202563786312 P; 07.04.2026 US 202619640468
(71) Applicant: MediaTek Inc., Hsinchu City 30078 (TW)
(72) Inventor: KUO, Yi-Ping, 30078 Hsinchu City (TW); YANG, Tzu-Hsien, 30078 Hsinchu City (TW); CHIU, Yi-Te, 30078 Hsinchu City (TW)
(74) Representative: Hoefer & Partner Patentanwälte mbB

(57) **Abstract**

A memory device (100) includes a memory array (102) and a plurality of bitlines (BL_{A}, BL_{B}, BLB_{A}, BLB_{B}). The bitlines (BL_{A}, BL_{B}, BLB_{A}, BLB_{B}) include a first bitline (BL_{A}). The first bitline (BL₄) includes a first bitline segment (108_1) and a second bitline segment (108_2). The first bitline segment (108_1) is routed on a first metal layer but not a second metal layer, and coupled to a plurality of first memory cells in the memory array (102), wherein the second metal layer is different from the first metal layer. The second bitline segment (108_2) is routed on the second metal layer but not the first metal layer, and coupled to the first memory cells through the first bitline segment. At least a portion of the first bitline segment (108_1) and at least a portion of the second bitline segment (108_2) are connected in a shunt configuration.

## Description

### Field of the Invention

The present invention relates to a memory design, and more particularly, to a memory device using shunt bitlines or shunt flying bitlines.

### Background of the Invention

For a variety of system on a chip (SoC) applications, a cache storage element can be used to temporarily retain data for further processing. The conventional approach for this cache storage element is using SRAM bit-cells. The SRAM bit-cells are arranged in rows and columns. Therefore, a read/write operation of an SRAM bit-cell is achieved through a wordline (WL) selection and a bitline (BL) selection. For example, during a read operation of the SRAM bit-cell, one bit value is read from the SRAM bit-cell through a complementary BL pair (BL, BLB); and during a write operation of the SRAM bit-cell, one bit value is written into the SRAM bit-cell through the complementary BL pair (BL, BLB). However, when SRAM bit-cells are manufactured using an advanced semiconductor process, bitline resistance is high and has impact on the read/write ability. Thus, there is a need for an innovative bitline design with reduced bitline resistance.

### Summary of the Invention

This in mind, the present invention aims at providing a memory device using shunt bitlines or shunt flying bitlines.

This is achieved by a memory device according to the independent claim. The dependent claims pertain to corresponding further developments and improvements. The scope of the invention is defined by the appended sets of claims.

As will be seen more clearly from the detailed description following below, the claimed memory device includes a memory array and a plurality of bitlines. The bitlines include a first bitline. The first bitline includes a first bitline segment and a second bitline segment. The first bitline segment is routed on a first metal layer but not a second metal layer, and coupled to a plurality of first memory cells in the memory array, wherein the second metal layer is different from the first metal layer. The second bitline segment is routed on the second metal layer but not the first metal layer, and coupled to the first memory cells through the first bitline segment. At least a portion of the first bitline segment and at least a portion of the second bitline segment are connected in a shunt configuration.

### Brief Description of the Drawings

In the following, the invention is further illustrated by way of example, taking reference to the accompanying drawings. Thereof
FIG. 1 is a diagram illustrating a memory device using shunt flying bitlines (FBLs) according to an embodiment of the present invention,
FIG. 2 is a diagram illustrating a cross-section of a first shunt FBL design according to an embodiment of the present invention,
FIG. 3 is a diagram illustrating a cross-section of a second shunt FBL design according to an embodiment of the present invention,
FIG. 4 is a diagram illustrating a cross-section of a third shunt FBL design according to an embodiment of the present invention,
FIG. 5 is a diagram illustrating a first memory device using shunt bitlines according to an embodiment of the present invention,
FIG. 6 is a diagram illustrating a cross-section of a first shunt bitline design according to an embodiment of the present invention.
FIG. 7 is a diagram illustrating a second memory device using shunt bitlines according to an embodiment of the present invention,
FIG. 8 is a diagram illustrating a cross-section of a second shunt bitline design according to an embodiment of the present invention,
FIG. 9 is a diagram illustrating a cross-section of a third shunt bitline design according to an embodiment of the present invention, and
FIG. 10 is a diagram illustrating a cross-section of a fourth shunt bitline design according to an embodiment of the present invention.

### Detailed Description

Certain terms are used throughout the following description and claims, which refer to particular components. As one skilled in the art will appreciate, electronic equipment manufacturers may refer to a component by different names. This document does not intend to distinguish between components that differ in name but not in function. In the following description and in the claims, the terms "include" and "comprise" are used in an open-ended fashion, and thus should be interpreted to mean "include, but not limited to ...". Also, the term "couple" is intended to mean either an indirect or direct electrical connection. Accordingly, if one device is coupled to another device, that connection may be through a direct electrical connection, or through an indirect electrical connection via other devices and connections.

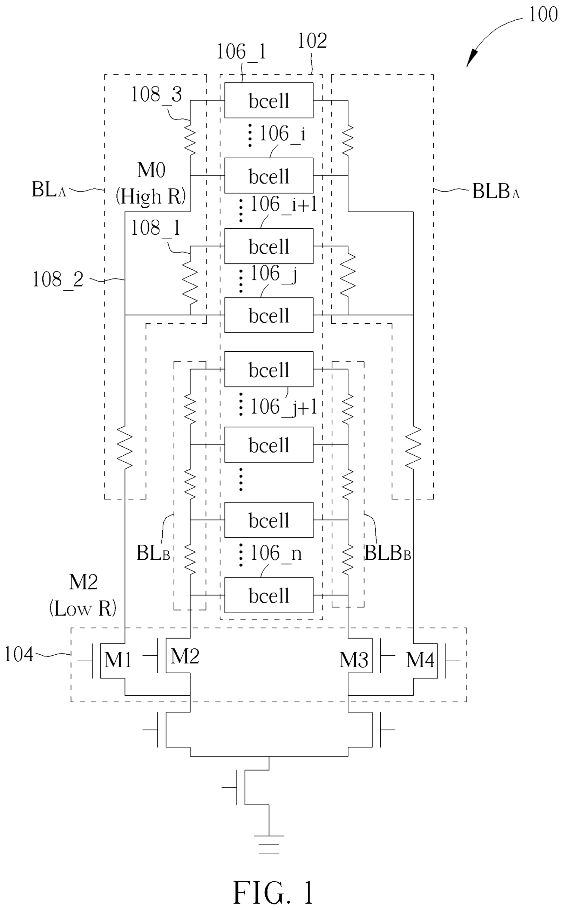

FIG. 1 is a diagram illustrating a memory device using shunt flying bitlines (FBLs) according to an embodiment of the present invention. The memory device 100 may be a high-density (HD) memory device including a memory array 102, a plurality of bitlines, and a peripheral circuit. The peripheral circuit acts as an input/output (I/O) circuit that is arranged to control access (read/write) of the memory array 102, and may include a multiplexer circuit 104 and other circuits including a row decoder, a timing controller, a column decoder, a sense amplifier, a write driver, etc. Since the present invention is focused on the bitline design, further description of the read/write control of the memory array 102 is omitted here for brevity.

The memory array 102 includes a plurality of memory cells arranged in a two-dimensional (2D) array with a plurality of rows and a plurality of columns. As shown in FIG. 1, each memory cell column includes a plurality of memory cells 106_1-106_n. It should be noted that the memory array 102 may include a plurality of memory cell columns. For better comprehension of technical features of the present invention, only a single memory cell column is illustrated in FIG. 1. In this embodiment, each memory cell of the memory array 102 may be a static random access memory (SRAM) bit-cell (labeled by "bcell"). For example, the memory cells 106_1-106_n may be typical 6T SRAM bit-cells. However, this is for illustrative purposes only, and is not meant to be a limitation of the present invention. In practice, any memory device using the proposed shunt FBLs falls within the scope of the present invention.

The memory cells 106_1-106_n located at the same memory cell column are connected to a complementary bitline pair (BL, BLB). In this embodiment, each bitline of the complementary bitline pair (BL, BLB) is implemented using separate bitlines with the aid of an FBL structure. Specifically, the bitline BL includes separate bitlines BL_{A} and BL_{B}, and the bitline BLB includes separate bitlines BLB_{A} and BLB_{B}. The multiplexer circuit 104 includes a plurality of transistors M1, M2, M3, M4 acting as YPASS gates. Each of the transistors M1-M4 is implemented by an N-channel metal-oxide-semiconductor (NMOS) transistor having a control terminal (e.g., gate terminal), a first connection terminal (e.g., drain terminal), and a second connection terminal (e.g., source terminal). One end of the bitline BL_{A} is connected to the first connection terminal of the transistor M1. One end of the bitline BL_{B} is connected to the first connection terminal of the transistor M2. The second connection terminal of the transistor M1 is connected to the second connection terminal of the transistor M2. Hence, the bitlines BL_{A} and BL_{B} belong to the same bitline BL, and can be selected through a 2:1 multiplexer consisting of transistors M1 and M2. When the transistor M1 is turned on and the transistor M2 is turned off, the bitline BL_{A} is selected (i.e., BL = BL_{A}), and the bitline BL_{B} is unselected. When the transistor M1 is turned off and the transistor M2 is turned on, the bitline BL_{A} is unselected, and the bitline BL_{B} is selected (i.e., BL = BL_{B}). The separate bitlines BL_{A} and BL_{B} with shorter lengths are not required to be selected at the same time, leading to a lower bitline load and a faster memory access speed.

Similarly, one end of the bitline BLB_{A} is connected to the first connection terminal of the transistor M4. One end of the bitline BLB_{B} is connected to the first connection terminal of the transistor M3. The second connection terminal of the transistor M4 is connected to the second connection terminal of the transistor M3. Hence, the bitlines BLB_{A} and BLB_{B} belong to the same bitline BLB, and can be selected through a 2:1 multiplexer consisting of transistors M3 and M4. When the transistor M4 is turned on and the transistor M3 is turned off, the bitline BL_{A} is selected (i.e., BL = BL_{A}), and the bitline BL_{B} is unselected. When the transistor M4 is turned off and the transistor M3 is turned on, the bitline BL_{A} is unselected, and the bitline BL_{B} is selected (i.e., BL = BL_{B}). The separate bitlines BLB_{A} and BLB_{B} with shorter lengths are not required to be selected at the same time, leading to a lower bitline load and a faster memory access speed.

Each bitline of the complementary bitline pair (BL, BLB) may employ the proposed shunt FBL design for bitline resistance reduction. The following takes the bitline BL as an example. The memory cells 106_1-106_n may be categorized into memory cells 106_1-106_j of a top memory cell sub-array and memory cells 106_j+1-106_n of a bottom memory cell sub-array. The memory cells 106_1-106_j of the top memory cell sub-array are coupled to the bitline BL_{A}. The memory cells 106_j+1-106_n of the bottom memory cell sub-array are coupled to the bitline BL_{B}. The bitline BL_{B} is routed on a first metal layer (e.g., M0) but not a second metal layer (e.g., M2 or higher metal layer). The bitline BL_{A} includes a plurality of bitline segments 108_1, 108_2, 108_3. Like the bitline BL_{B}, the bitline segments 108_1 and 108_3 are routed on the first metal layer (e.g., M0) but not the second metal layer (e.g., M2 or higher metal layer). The bitline segment 108_3 is coupled to memory cells 106_1-106_i of the top memory cell sub-array. The bitline segment 108_1 is coupled to memory cells 106_i+1-106_j of the top memory cell sub-array. For example, n = 2*j and j=2*i. The bitline segment 108_2 is a flying bitline (FBL) that is routed on the second metal layer (e.g., M2 or higher metal layer) but not the first metal layer (e.g., M0). The bitline segment 108_2 is coupled to memory cells 106_1-106_i of the top memory cell sub-array through the bitline segment 108_3, and is coupled to memory cells 106_i+1-106_n of the bottom memory cell sub-array through the bitline segment 108_1. The bitline segment 108_2 routed on the second metal layer (e.g., M2 or higher metal layer) acts as an extension of the bitline segments 108_1, 108_3 routed on the first metal layer (e.g., M0), and is across the memory cells 106_j+1-106_n of the bottom memory cell sub-array. Specifically, with the aid of the FBL (i.e., bitline segment 108_2) and the 2:1 multiplexer (i.e., transistors M1 and M2), the bitline segments 108_1 and 108_3 can be selected under a condition that the bitline BL_{B} is unselected.

In accordance with the proposed shunt FBL design, at least a portion (i.e., part or all) of a non-FBL segment and at least a portion (i.e., part or all) of an FBL segment are connected in a shunt configuration. Regarding the embodiment shown in FIG. 1, a portion of the bitline segment 108_2 and the bitline segment 108_1 are connected in a shunt configuration.

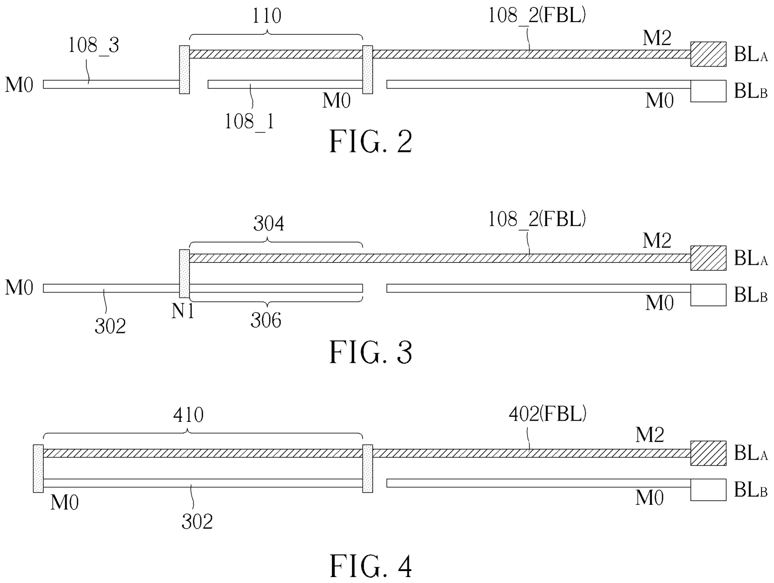

FIG. 2 is a diagram illustrating a cross-section of a first shunt FBL design according to an embodiment of the present invention. The memory device 100 shown in FIG. 1 may employ the first shunt FBL design shown in FIG. 2. One end of the bitline segment 108_1 and one end of the bitline segment 108_3 are connected to two ends of a partial bitline segment 110 of the bitline segment 108_2, respectively. For example, the M2 bitline segment 108_2 may be connected to M0 bitline segments 108_1 and 108_3 through vias. Compared to a bitline segment routed on the first metal layer (e.g., M0), a bitline segment routed on the second metal layer (e.g., M2 or higher metal layer) has lower resistance due to inherent characteristics of the second metal layer (e.g., M2 or higher metal layer). The parallel connection of the M0 bitline segment 108_1 and the M2 partial bitline segment 110 enables the bitline BL_{A} to have lower resistance, thereby improving the write ability under a high voltage (HV) operation.

FIG. 3 is a diagram illustrating a cross-section of a second shunt FBL design according to an embodiment of the present invention. The memory device 100 may be modified to employ the second shunt FBL design. Specifically, separate bitline segments 108_1 and 108_3 are replaced by a single bitline segment 302. The bitline segment 302 is routed on the first metal layer (e.g., M0) but not the second metal layer (e.g., M2 or higher metal layer), and is coupled to memory cells 106_1-106_j of the top memory cell sub-array. The bitline segment 108_2 is coupled to the memory cells 106_1-106_j of the top memory cell sub-array through the bitline segment 302. In this embodiment, the bitline segment 108_1 is connected to at least one intermediate node N1 of the bitline segment 302. For example, the M2 bitline segment 108_2 may be connected to the M0 bitline segment 302 through via. The parallel connection of a partial bitline segment 306 of the M0 bitline segment 302 and a partial bitline segment 304 of the M2 bitline segment 108_2 enables the bitline BL_{A} to have lower resistance, thereby improving the write ability under an HV operation.

FIG. 4 is a diagram illustrating a cross-section of a third shunt FBL design according to an embodiment of the present invention. The memory device 100 may be modified to employ the third shunt FBL design. Specifically, separate bitline segments 108_1 and 108_3 are replaced by the single bitline segment 302, and the bitline segment 108_1 is replaced by a bitline segment 402 having a partial bitline segment 410 with a length equal to that of the bitline segment 302. The bitline segment 302 is routed on the first metal layer (e.g., M0) but not the second metal layer (e.g., M2 or higher metal layer), and is coupled to memory cells 106_1-106_j of the top memory cell sub-array. The bitline segment 402 is routed on the second metal layer (e.g., M2 or higher metal layer) but not the first metal layer (e.g., M0). The bitline segment 402 is coupled to the memory cells 106_1-106_j of the top memory cell sub-array through the bitline segment 302. In this embodiment, two ends of the partial bitline segment 410 are connected to two ends of the bitline segment 302, respectively. For example, the M2 bitline segment 402 may be connected to the M0 bitline segment 302 through vias. The parallel connection of the M0 bitline segment 302 and the M2 partial bitline segment 410 enables the bitline BL_{A} to have lower resistance, thereby improving the write ability under an HV operation.

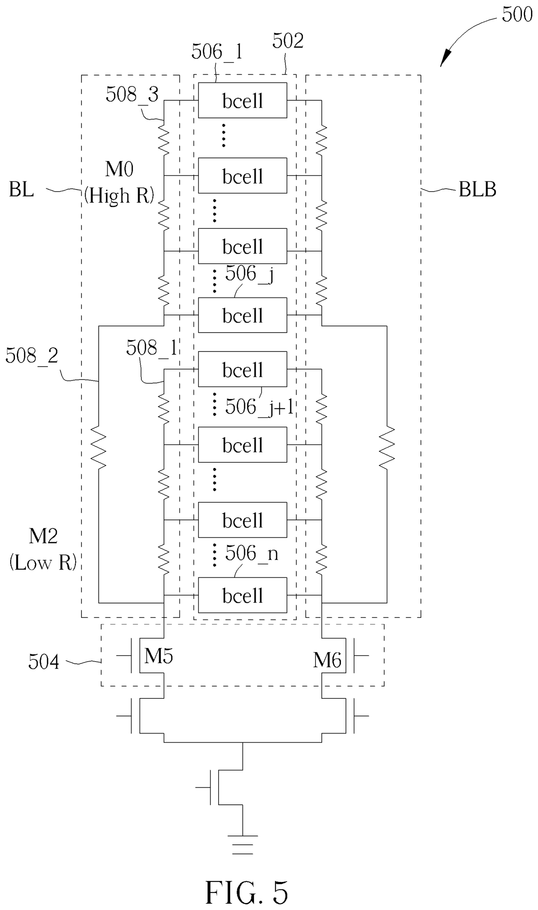

FIG. 5 is a diagram illustrating a first memory device using shunt bitlines according to an embodiment of the present invention. The memory device 500 may be an HD memory device including a memory array 502, a plurality of bitlines (e.g., BL and BLB), and a peripheral circuit. The peripheral circuit acts as an I/O circuit that is arranged to control access (read/write) of the memory array 502, and may include a multiplexer circuit 504 and other circuits including a row decoder, a timing controller, a column decoder, a sense amplifier, a write driver, etc. Since the present invention is focused on the bitline design, further description of the read/write control of the memory array 502 is omitted here for brevity.

The memory array 502 includes a plurality of memory cells arranged in a 2D array with a plurality of rows and a plurality of columns. As shown in FIG. 5, each memory cell column includes a plurality of memory cells 506_1-506_n. It should be noted that the memory array 502 may include a plurality of memory cell columns. For better comprehension of technical features of the present invention, only a single memory cell column is illustrated in FIG. 5. In this embodiment, each memory cell of the memory array 502 may be an SRAM bit-cell (labeled by "bcell"). For example, the memory cells 506_1-506_n may be typical 6T SRAM bit-cells. However, this is for illustrative purposes only, and is not meant to be a limitation of the present invention. In practice, any memory device using the proposed shunt bitlines falls within the scope of the present invention.

The memory cells 506_1-506_n located at the same memory cell column are connected to a complementary bitline pair (BL, BLB). The multiplexer circuit 504 includes a plurality of transistors M5, M6 acting as YPASS gates. Each of the transistors M5, M6 is implemented by an NMOS transistor having a control terminal (e.g., gate terminal), a first connection terminal (e.g., drain terminal), and a second connection terminal (e.g., source terminal). One end of the bitline BL is connected to the first connection terminal of the transistor M5. One end of the bitline BLB is connected to the first connection terminal of the transistor M6. The second connection terminal of the transistor M5 is separated from the second connection terminal of the transistor M6. When the transistor M5 is turned on, the bitline BL is selected. When the transistor M5 is turned off, the bitline BL is unselected. When the transistor M6 is turned on, the bitline BLB is selected. When the transistor M6 is turned off, the bitline BLB is unselected. Since the bitline BL is paired with the bitline BLB, control terminals of transistor M5 and M6 may receive the same control voltage. Compared to the multiplexer circuit 104 shown in FIG. 1, the multiplexer circuit 504 requires fewer YPASS gates. In this way, the memory device 500 using the proposed shunt bitlines has a smaller area.

Each bitline of the complementary bitline pair (BL, BLB) may employ the proposed shunt bitline design for bitline resistance reduction. The following takes the bitline BL as an example. The memory cells 506_1-506_n may be categorized into memory cells 506_1-506_j of a top memory cell sub-array and memory cells 506_j+1-506_n of a bottom memory cell sub-array. For example, n = 2*j. The bitline BL includes a plurality of bitline segments 508_1, 508_2, 508_3. The memory cells 506_1-506_j of the top memory cell sub-array are coupled to the bitline segment 508_3. The memory cells 506_j+1-506_n of the bottom memory cell sub-array are coupled to the bitline segment 508_1. The bitline segments 508_1 and 508_3 are routed on a first metal layer (e.g., M0) but not a second metal layer (e.g., M2 or higher metal layer). The bitline segment 508_2 is routed on the second metal layer (e.g., M2 or higher metal layer) but not the first metal layer (e.g., M0). As shown in FIG. 5, one end of the bitline segment 508_1 and one end of the bitline segment 508_2 are jointly connected to the same first connection terminal of the transistor M5. Hence, the bitline segment 508_2, by definition, does not function as an FBL due to the fact that bitline segments 508_1-508_3 are all selected when the transistor M5 is turned on. In this embodiment, the bitline segment 508_2 is coupled to the bitline segment 508_1, and is further coupled between the transistor M5 and the bitline segment 508_3. Hence, the bitline segment 508_2 is coupled to memory cells 506_1-506_j of the top memory cell sub-array through the bitline segment 508_3, and is coupled to memory cells 506_j+1-506_n of the bottom memory cell sub-array through the bitline segment 508_1.

In accordance with the proposed shunt bitline design, at least a portion (i.e., part or all) of one bitline (non-FBL) segment routed on one metal layer and at least a portion (i.e., part or all) of another bitline (non-FBL) segment routed on another metal layer are connected in a shunt configuration. Regarding the embodiment shown in FIG. 5, the bitline segments 508_1 and 508_2 are connected in a shunt configuration.

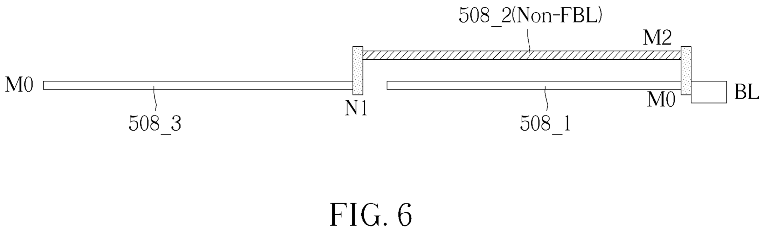

FIG. 6 is a diagram illustrating a cross-section of a first shunt bitline design according to an embodiment of the present invention. The memory device 500 shown in FIG. 5 may employ the first shunt bitline design shown in FIG. 6. One end of the bitline segment 508_1 and one end of the bitline segment 508_3 are connected to two ends of the bitline segment 508_2, respectively. For example, the M2 bitline segment 508_2 may be connected to M0 bitline segments 508_1 and 508_3 through vias. Compared to a bitline segment routed on the first metal layer (e.g., M0), a bitline segment routed on the second metal layer (e.g., M2 or higher metal layer) has lower resistance due to inherent characteristics of the second metal layer (e.g., M2 or higher metal layer). The parallel connection of the M0 bitline segment 508_1 and the M2 bitline segment 508_2 enables the bitline BL to have lower resistance, thereby improving the write ability under an HV operation.

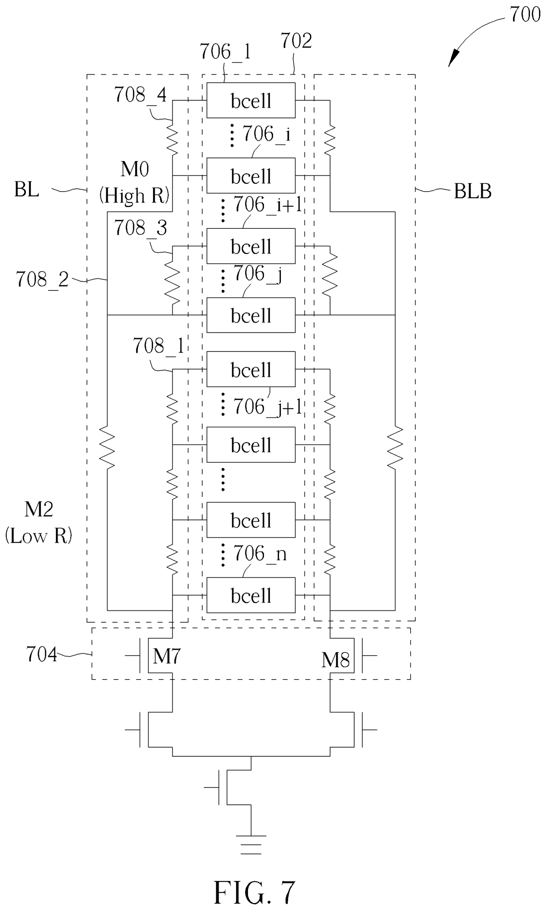

FIG. 7 is a diagram illustrating a second memory device using shunt bitlines according to an embodiment of the present invention. The memory device 700 may be an HD memory device including a memory array 702, a plurality of bitlines (e.g., BL and BLB), and a peripheral circuit. The peripheral circuit acts as an I/O circuit that is arranged to control access (read/write) of the memory array 702, and may include a multiplexer circuit 704 and other circuits including a row decoder, a timing controller, a column decoder, a sense amplifier, a write driver, etc. Since the present invention is focused on the bitline design, further description of the read/write control of the memory array 702 is omitted here for brevity.

The memory array 702 includes a plurality of memory cells arranged in a 2D array with a plurality of rows and a plurality of columns. As shown in FIG. 7, each memory cell column includes a plurality of memory cells 706_1-706_n. It should be noted that the memory array 702 may include a plurality of memory cell columns. For better comprehension of technical features of the present invention, only a single memory cell column is illustrated in FIG. 7. In this embodiment, each memory cell of the memory array 702 may be an SRAM bit-cell (labeled by "bcell"). For example, the memory cells 706_1-706_n may be typical 6T SRAM bit-cells. However, this is for illustrative purposes only, and is not meant to be a limitation of the present invention. In practice, any memory device using the proposed shunt bitlines falls within the scope of the present invention.

The memory cells 706_1-706_n located at the same memory cell column are connected to a complementary bitline pair (BL, BLB). The multiplexer circuit 704 includes a plurality of transistors M7, M8 acting as YPASS gates. Each of the transistors M7, M8 is implemented by an NMOS transistor having a control terminal (e.g., gate terminal), a first connection terminal (e.g., drain terminal), and a second connection terminal (e.g., source terminal). One end of the bitline BL is connected to the first connection terminal of the transistor M7. One end of the bitline BLB is connected to the first connection terminal of the transistor M8. The second connection terminal of the transistor M7 is separated from the second connection terminal of the transistor M8. When the transistor M7 is turned on, the bitline BL is selected. When the transistor M7 is turned off, the bitline BL is unselected. When the transistor M8 is turned on, the bitline BLB is selected. When the transistor M8 is turned off, the bitline BLB is unselected. Since the bitline BL is paired with the bitline BLB, control terminals of transistor M7 and M8 may receive the same control voltage. Compared to the multiplexer circuit 104 shown in FIG. 1, the multiplexer circuit 704 requires fewer YPASS gates. In this way, the memory device 700 using the proposed shunt bitlines has a smaller area.

Each bitline of the complementary bitline pair (BL, BLB) may employ the proposed shunt bitline design for bitline resistance reduction. The following takes the bitline BL as an example. The memory cells 706_1-706_n may be categorized into memory cells 706_1-706_j of a top memory cell sub-array and memory cells 706_j+1-706_n of a bottom memory cell sub-array. The bitline BL includes a plurality of bitline segments 708_1, 708_2, 708_3, 708_4. The memory cells 706_1-706_i of the top memory cell sub-array are coupled to the bitline segment 708_4. The memory cells 706_i+1-706_j of the top memory cell sub-array are coupled to the bitline segment 708_3. The memory cells 706_j+1-706_n of the bottom memory cell sub-array are coupled to the bitline segment 708_1. For example, n = 2*j and j = 2*i.

The bitline segments 708_1, 708_3, 708_4 are routed on a first metal layer (e.g., M0) but not a second metal layer (e.g., M2 or higher metal layer). The bitline segment 708_2 is routed on the second metal layer (e.g., M2 or higher metal layer) but not the first metal layer (e.g., M0). As shown in FIG. 7, one end of the bitline segment 708_1 and one end of the bitline segment 708_2 are jointly connected to the same first connection terminal of the transistor M7. Hence, the bitline segment 708_2, by definition, does not function as an FBL due to the fact that bitline segments 708_1-708_4 are all selected when the transistor M7 is turned on. In this embodiment, the bitline segment 708_2 is coupled to the bitline segment 708_1, and is further coupled between the transistor M7 and the bitline segments 708_3, 708_4. Hence, the bitline segment 708_2 is coupled to memory cells 706_1-706_i and memory cells 706_i+1-706_j of the top memory cell sub-array through the bitline segments 708_4 and 708_3, respectively, and is coupled to memory cells 706_j+1-706_n of the bottom memory cell sub-array through the bitline segment 708_1.

In accordance with the proposed shunt bitline design, at least a portion (i.e., part or all) of one bitline (non-FBL) segment routed on one metal layer and at least a portion (i.e., part or all) of another bitline (non-FBL) segment routed on another metal layer are connected in a shunt configuration. Regarding the embodiment shown in FIG. 7, a first part of the bitline segment 708_2 and the bitline segment 708_1 are connected in a shunt configuration, and a second part of the bitline segment 708_2 and the bitline segment 708_3 are also connected in a shunt configuration.

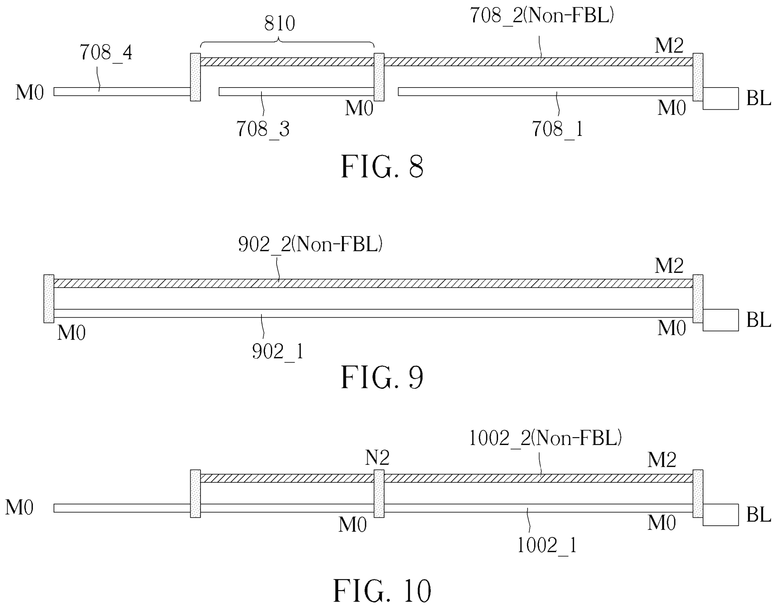

FIG. 8 is a diagram illustrating a cross-section of a second shunt bitline design according to an embodiment of the present invention. The memory device 700 shown in FIG. 7 may employ the second shunt bitline design shown in FIG. 8. One end of the bitline segment 708_4 and one end of the bitline segment 708_3 are connected to two ends of a partial bitline segment 810 of the bitline segment 708_2, respectively. For example, the M2 bitline segment 708_2 may be connected to M0 bitline segments 708_1, 708_3 through vias. Compared to a bitline segment routed on the first metal layer (e.g., M0), a bitline segment routed on the second metal layer (e.g., M2 or higher metal layer) has lower resistance due to inherent characteristics of the second metal layer (e.g., M2 or higher metal layer). The parallel connection of the bitline segment 708_1/708_3 and the bitline segment 708_2 enables the bitline BL to have lower resistance, thereby improving the write ability under an HV operation.

FIG. 9 is a diagram illustrating a cross-section of a third shunt bitline design according to an embodiment of the present invention. The memory device 500 (or memory device 700) may be modified to employ the third shunt bitline design. Specifically, separate bitline segments 508_1 and 508_3 (or separate bitline segments 708_1, 708_3, and 708_4) are replaced by a single bitline segment 902_1, and the bitline segment 508_2 (or bitline segment 708_2) is replaced by a bitline segment 902_2 with a length equal to that of the bitline segment 902_1. The bitline segment 902_1 is routed on the first metal layer (e.g., M0) but not the second metal layer (e.g., M2 or higher metal layer), and is coupled to all memory cells 506_1-506_n located at the same memory cell column (or all memory cells 706_1-706_n located at the same memory cell column). The bitline segment 902_2 is routed on the second metal layer (e.g., M2 or higher metal layer) but not the first metal layer (e.g., M0). In this embodiment, a first end of the bitline segment 902_1 is connected to a first end of the bitline segment 902_2, and a second end of the bitline segment 902_1 is connected to a second end of the bitline segment 902_2. For example, the M2 bitline segment 902_2 may be connected to the M0 bitline segment 902_1 through vias. The parallel connection of bitline segments 902_1 and 902_2 enables the bitline BL to have lower resistance, thereby improving the write ability under an HV operation.

FIG. 10 is a diagram illustrating a cross-section of a fourth shunt bitline design according to an embodiment of the present invention. The memory device 500 (or memory device 700) may be modified to employ the fourth shunt bitline design. Specifically, separate bitline segments 508_1 and 508_3 (or separate bitline segments 708_1, 708_3, and 708_4) are replaced by a single bitline segment 1002_1, and the bitline segment 508_2 (or bitline segment 708_2) is replaced by a bitline segment 1002_2. The bitline segment 1002_1 is routed on the first metal layer (e.g., M0) but not the second metal layer (e.g., M2 or higher metal layer), and is coupled to all memory cells 506_1-506_n located at the same memory cell column (or memory cells 706_1-706_n located at the same memory cell column). The bitline segment 1002_2 is routed on the second metal layer (e.g., M2 or higher metal layer) but not the first metal layer (e.g., M0). In this embodiment, two ends and at least one intermediate node N2 of the bitline segment 1002_2 are connected to the bitline segment 1002_1. For example, the M2 bitline segment 1002_2 may be connected to the M0 bitline segment 1002_1 through vias. The parallel connection of bitline segments 1002_1 and 1002_2 enables the bitline BL to have lower resistance, thereby improving the write ability under an HV operation.

## Claims

1. A memory device (100, 500, 700) **characterized by**:
a memory array (102, 502, 702); and
a plurality of bitlines (BL_{A}, BL_{B}, BLB_{A}, BLB_{B}, BL, BLB), comprising:
a first bitline (BL_{A}, BL), comprising:
a first bitline segment (108_1, 508_1, 708_1), routed on a first metal layer (M0) but not a second metal layer (M2), and coupled to a plurality of first memory cells in the memory array (102, 502, 702), wherein the second metal layer (M2) is different from the first metal layer (M0); and
a second bitline segment (108_2, 508_2, 708_2), routed on the second metal layer (M2) but not the first metal layer (M0), and coupled to the plurality of first memory cells through the first bitline segment (108_1, 508_1, 708_1);
wherein at least a portion of the first bitline segment (108_1, 508_1, 708_1) and at least a portion of the second bitline segment (108_2, 508_2, 708_2) are connected in a shunt configuration.

2. The memory device (100) of claim 1, **characterized in that** the memory device (100) further comprises:
a multiplexer circuit (104), comprising:
a first transistor (M1), having a control terminal, a first connection terminal, and a second connection terminal, wherein the second bitline segment (108_2) is coupled between the first bitline segment (108_1) and the first connection terminal of the first transistor (M1); and
a second transistor (M2), having a control terminal, a first connection terminal, and a second connection terminal, wherein the second connection terminal of the second transistor (M2) is coupled to the second connection terminal of the first transistor (M1);
the plurality of bitlines further comprise:
a second bitline (BL_{B}), routed on the first metal layer (M0) but not the second metal layer (M2), and coupled to a plurality of second memory cells in the memory array (102), wherein one end of the second bitline (BL_{B}) is coupled to the first connection terminal of the second transistor (M2), and the plurality of first memory cells and the plurality of second memory cells are located at a same column.

3. The memory device (100) of claim 2, **characterized in that** the first bitline (BL_{A}) further comprises:
a third bitline segment (108_3), routed on the first metal layer (M0) but not the second metal layer (M2), and coupled to a plurality of third memory cells in the memory array (102), wherein the plurality of first memory cells, the plurality of second memory cells, and the plurality of third memory cells are located at the same column;
wherein one end of the first bitline segment (108_1) and one end of the third bitline segment (108_3) are connected to two ends of a partial bitline segment (110) of the second bitline segment (108_2), respectively.

4. The memory device (100) of claim 2, **characterized in that** the second bitline segment (108_2) is connected to at least one intermediate node of the first bitline segment (302).

5. The memory device of claim 2, **characterized in that** two ends of a partial bitline segment (410) of the second bitline segment (402) are connected to two ends of the first bitline segment (302), respectively.

6. The memory device (500, 700) of claim 1, **characterized in that** the memory device (500, 700) further comprises:
a multiplexer circuit (504, 704), comprising:
a transistor (M5, M7), having a control terminal, a first connection terminal, and a second connection terminal, wherein one end of the first bitline segment (508_1, 708_1) and one end of the second bitline segment (508_2, 708_2) are jointly connected to the first connection terminal of the transistor (M5, M7).

7. The memory device (500) of claim 6, **characterized in that** the first bitline (BL) further comprises:
a third bitline segment (508_3), routed on the first metal layer (M0) but not the second metal layer (M1), and coupled to a plurality of second memory cells in the memory array (502), wherein the plurality of first memory cells and the plurality of second memory cells are located at a same column, and one end of the first bitline segment (508_1) and one end of the third bitline segment (508_3) are connected to two ends of the second bitline segment (508_2), respectively.

8. The memory device (700) of claim 6, **characterized in that** the first bitline (BL) further comprises:
a third bitline segment (708_3), routed on the first metal layer (M0) but not the second metal layer (M2), and coupled to a plurality of second memory cells in the memory array (702); and
a fourth bitline segment (708_4), routed on the first metal layer (M0) but not the second metal layer (M2), and coupled to a plurality of third memory cells in the memory array (702), wherein the plurality of first memory cells, the plurality of second memory cells, and the plurality of third memory cells are located at a same column, and one end of the third bitline segment (708_3) and one end of the fourth bitline segment (708_4) are connected to two ends of a partial bitline segment (810) of the second bitline segment (708_2), respectively.

9. The memory device (500, 700) of claim 6, **characterized in that** a first end of the second bitline segment (902_2) is connected to a first end of the first bitline segment (902_1), and a second end of the second bitline segment (902_2) is connected to a second end of the first bitline segment (902_1).

10. The memory device (500, 700) of claim 6, **characterized in that** two ends and at least one intermediate node of the second bitline segment (1002_2) are connected to the first bitline segment (1002_1).

11. The memory device (200) of claim 1, **characterized in that** the second bitline segment (108_2) is a flying bitline segment.

12. The memory device (200) of claim 11, **characterized in that** the first bitline (BL_{A}) further comprises:
a third bitline segment (108_3), routed on the first metal layer (M0) but not the second metal layer (M2), and coupled to a plurality of second memory cells in the memory array (102), wherein the plurality of first memory cells and the plurality of second memory cells are located at the same column, one end of the first bitline segment (108_1) and one end of the third bitline segment (108_3) are connected to two ends of a partial bitline segment (110) of the second bitline segment, respectively; or
wherein the second bitline segment (108_2) is connected to at least one intermediate node of the first bitline segment (302); or
wherein two ends of a partial bitline segment (410) of the second bitline segment (402) are connected to two ends of the first bitline segment (302), respectively.

13. The memory device (500, 700) of claim 1, **characterized in that** the second bitline segment (108_2) is not a flying bitline segment.

14. The memory device (500, 700) of claim 13, **characterized in that** the first bitline (BL) further comprises:
a third bitline segment (508_3), routed on the first metal layer (M0) but not the second metal layer (M1), and coupled to a plurality of second memory cells in the memory array (502), wherein the plurality of first memory cells and the plurality of second memory cells are located at a same column, and one end of the first bitline segment (508_1) and one end of the third bitline segment (508_3) are connected to two ends of the second bitline segment (508_2), respectively; or
wherein the first bitline (BL) further comprises:
a third bitline segment (708_3), routed on the first metal layer (M0) but not the second metal layer (M2), and coupled to a plurality of second memory cells in the memory array (702); and
a fourth bitline segment (708_4), routed on the first metal layer (M0) but not the second metal layer (M2), and coupled to a plurality of third memory cells in the memory array (702), wherein the plurality of first memory cells, the plurality of second memory cells, and the plurality of third memory cells are located at a same column, and one end of the third bitline segment (708_3) and one end of the fourth bitline segment (708_4) are connected to two ends of a partial bitline segment (810) of the second bitline segment (708_2), respectively; or
wherein a first end of the second bitline segment (902_2) is connected to a first end of the first bitline segment (902_1), and a second end of the second bitline segment (902_2) is connected to a second end of the first bitline segment (902_1); or
wherein two ends and at least one intermediate node of the second bitline segment (1002_2) are connected to the first bitline segment (1002_1).

15. The memory device (100, 500, 700) of claim 1, **characterized in that** each memory cell of the memory array is a static random access memory, SRAM, bit-cell.
